(19) Europäisches Patentamt
European Patent Office
Office européen des brevets

(11) **EP 3 000 786 A1**

(12) **EUROPEAN PATENT APPLICATION**

(43) Date of publication:
**30.03.2016 Bulletin 2016/13**

(51) Int Cl.:
***C01G 11/00*** (2006.01)    ***H01L 31/0224*** (2006.01)
***H01L 31/0296*** (2006.01)    ***H01L 31/18*** (2006.01)

(21) Application number: **14186931.3**

(22) Date of filing: **29.09.2014**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Danmarks Tekniske Universitet
2800 Lyngby (DK)**

(72) Inventors:
• **Pryds, Nini
2791 Dragør (DK)**

• **Han, Li
4000 Roskilde (DK)**
• **Christensen, Dennis Valbjørn
4920 Søllested (DK)**
• **Linderoth, Søren
4000 Roskilde (DK)**

(74) Representative: **Plougmann Vingtoft a/s
Rued Langgaards Vej 8
2300 Copenhagen S (DK)**

(54) **Semiconductor comprising gallium doped zinc cadmium oxide**

(57) There is presented an n-type semiconductor which may be useful as a TCO material: gallium doped zinc cadmium oxide (which may be interchangeably referred to as: Ga-doped ZnCdO) with the general formula $Zn_{1-x-y}Cd_xGa_yO$, where x and y may in a particular embodiment be given by, e.g., 0.05<x<0.15, 0.006<y<0.04. The semiconductor has excellent high transparency, with minor light absorption over the solar spectra, and high electrical conductivity, and may be provided in a relatively cost effective manner, and may furtermore be seen as less costly, and/or more stable and/or having lower resistivity and/or being more transparent, and optionally being depositable at room temperature, compared to known materials. The material has been successfully synthesized and tested in the laboratory.

FIG. 6

EP 3 000 786 A1

**Description**

FIELD OF THE INVENTION

The present invention relates to semiconductors, more particularly n-type semiconductors comprising gallium doped zinc cadmium oxide $Zn_zCd_xGa_yO$ and a corresponding device comprising said n-type semiconductor, a method for preparing said n-type semiconductor and use of said n-type semiconductor.

BACKGROUND OF THE INVENTION

Transparent conductive oxide (TCO) materials are extensively used in optoelectronic devices such as displays, multifunctional windows, and solar cells. As the demand for private electronics and solar panels are rapidly increasing, the world is calling for TCOs with lower prices, and better performances, such as lower resistivity and more transparent materials.

Today, tin-doped indium oxide (ITO) is a dominant material for TCOs. However, it comprises Indium, which is a very expensive and scarce material, and may not have optimal properties, such as in terms of resistivity and transparence.

Hence, a material, which may optionally be employed as a TCO material, would be advantageous, and in particular a less costly, and/or more stable material and/or a material which has lower resistivity and/or is more transparent would be advantageous.

SUMMARY OF THE INVENTION

In particular, it may be seen as an object of the present invention to provide a less costly, and/or more stable material and/or a material which has lower resistivity and/or is more transparent.

It is a further object of the present invention to provide an alternative to the prior art.

Thus, the above described object and several other objects are intended to be obtained in a first aspect of the invention by providing an n-type semiconductor comprising gallium doped zinc cadmium oxide $Zn_zCd_xGa_yO$, optionally doped with one or more further dopants, wherein:

- the value of x is equal to or larger than 0.050,
- the value of x is equal to or less than 0.150,
- the value of y is equal to or larger than 0.001,
- the value of y is equal to or less than 0.019,
- the value of z is equal to or larger than 0.300, such as at least 0.500, such as at least 0.750, such as at least 0.800, such as at least 0.850, such as a least 0.900,

and/or wherein

- the value of x is equal to or larger than 0.081,
- the value of x is equal to or less than 0.150,
- the value of y is equal to or larger than 0.001,
- the value of y is equal to or less than 0.040,
- the value of z is equal to or larger than 0.300, such as at least 0.500, such as at least 0.750, such as at least 0.800, such as at least 0.850, such as a least 0.900.

The invention may be particularly, but not exclusively, advantageous for obtaining an n-type semiconductor with particularly beneficial properties, such as being less costly, and/or more stable and/or having lower resistivity and/or being more transparent, and optionally being depositable at room temperature, compared to known materials. The material has been successfully synthesized and tested in the laboratory. The material shows very good properties, such as being suitable as a TCO material.

The present inventors have developed a new n-type semiconductor which may be useful as a TCO material: gallium doped zinc cadmium oxide (which may be interchangeably referred to as: Ga-doped ZnCdO) with the general formula $Zn_{1-x-y}Cd_xGa_yO$, where x and y may in a particular embodiment be given by, e.g., 0.05<x<0.15, 0.006<y<0.04. The semiconductor has excellent high transparency, with minor light absorption over the solar spectra, and high electrical conductivity, and may be provided in a relatively cost effective manner. The material may also be seen as stable at high temperatures, which may make it attractive also for high temperature applications. For example, The aluminum doped zinc oxide (AZO) is vulnerable to damp and heat conditions and degrades rapidly above 300°C. The inventive n-type semiconductor comprising Ga-doped ZnCdO may be seen as a stable ternary compound, which has higher thermal and chemical stability than AZO.

The composition of the semiconductor enables that it can be deposited in a form of thin film (sub micrometer to a few micrometers and more) with various deposition methods suitable for integrated fabrication of transparent conductive materials, including pulsed laser deposition (PLD), metal organic chemical vapor deposition (MOCVD), metal organic molecular beam deposition (MOMBD), spray pyrolysis, magnetron sputtering or and other deposition techniques. The films can be fabricated with different microstructures ranging from amorphous to polycrystalline. Deposition at temperatures ranging from room temperature (RT) as well as up to 800°C is possible. Thus the substrate can be polymers, glass, and other crystalline materials.

The values x, y, z, are to be understood as the amount of the element in the composition with respect to the amount of Zn in a ZnO composition. The values x and y may be referred to as the doping ratio or the doping fraction, corresponding to the ratio between the number $N_{\text{atoms of the dopant Cd}}$ and $N_{\text{atoms of the dopant Ga}}$ of, respectively, Cd and Ga, and the number $N_{\text{atoms of Zn in ZnO}}$ of Zn atoms in a corresponding ZnO composition, such as:

$$x = \left(N_{\text{atoms of the dopant Cd}}\right)/\left(N_{\text{atoms of Zn in ZnO}}\right)$$

$$y = \left(N_{\text{atoms of the dopant Ga}}\right)/\left(N_{\text{atoms of Zn in ZnO}}\right)$$

It is further to be understood, that where the amount scales from 0 (corresponding to the corresponding element not being present) to 1 (corresponding to all of the Zn in a corresponding ZnO material being replaced in the case of the sum of x and y being 1, or to all of the Zn still being present in the case of z being 1 correspondong to ZnO).

For example, if x is 0.1, it corresponds to a ZnO structure where every 10th Zn atom in a corresponding ZnO material has been replaced with a Cd atom. If no other elements are present in the material, the Zn:Cd ratio is then 9:1. If other elements are present (as dopants instead of Zn), the Zn:Cd ratio is then below 9:1.

For example, if x is 0.1 and y is 0.01, it corresponds to a ZnO structure where every 10th Zn atom in a corresponding ZnO material has been replaced with a Cd atom, and where every 100th Zn atom in a corresponding ZnO material has been replaced with a Ga atom. If no other elements are present in the material, the Zn:Cd ratio is then 89:10 and the Zn:Ga ratio is 89:1 and the Cd:Ga ratio is x:y = 10:1. If other elements are present (as dopants instead of Zn), the Zn:Cd ratio is then below 89:1 and the Zn: Ga ratio is the below 89:1 but the Zn: Ga ratio remains x:y = 10:1.

By 'optionally doped with one or more further dopants' it may be understood, that the formula $Zn_zCd_xGa_yO$ implies the presence of the elements in the formula, but does not exclude the presence of other elements, such as one or more further dopants, such as Sc, Sn and/or Ce. Accordingly, the formula could be written $Zn_zCd_xGa_yA_wO$, where A corresponds to one or more optional dopants, such as Sc, Sn and/or Ce. The amount w may in embodiments be 0 (corresponding to no further dopants). The amount w may in embodiments be less than 0.5, such as less than 0.2, such as less than 0.1, such as less than 0.01, such as less than 0.001 (corresponding to no further dopants or a limited amount of further dopants).

In an embodiment, there is presented an n-type semiconductor, wherein:

- the value of x is equal to or larger than 0.081,
- the value of x is equal to or less than 0.150,
- the value of y is equal to or larger than 0.001,
- the value of y is equal to or less than 0.019.

An advantage of this embodiment may be that a semiconductor defined by these values may have relatively low resistivity.

In an embodiment, there is presented an n-type semiconductor, wherein:

- the value of x is equal to or larger than 0.081,
- the value of x is equal to or less than 0.120,
- the value of y is equal to or larger than 0.005,
- the value of y is equal to or less than 0.016.

An advantage of this embodiment may be that a semiconductor defined by these values may have relatively low resistivity.

In an embodiment, there is presented an n-type semiconductor, wherein:

- the value of x is equal to or larger than 0.085,

- the value of x is equal to or less than 0.130,
- the value of y is equal to or larger than 0.005,
  the value of y is equal to or less than 0.019.

An advantage of this embodiment may be that a semiconductor defined by these values may have relatively low resistivity.
In an embodiment, there is presented an n-type semiconductor, wherein:

- the value of x is equal to or larger than 0.085,
- the value of x is equal to or less than 0.120,
- the value of y is equal to or larger than 0.006,
- the value of y is equal to or less than 0.015.

An advantage of this embodiment may be that a semiconductor defined by these values may have relatively low resistivity.
In an embodiment, there is presented an n-type semiconductor, wherein:

- the value of x is equal to or larger than 0.085,
- the value of x is equal to or less than 0.120,
- the value of y is equal to or larger than 0.006,
- the value of y is equal to or less than 0.015,
- the value of z is equal to or less than 1-x-y.

An advantage of this embodiment may be that a semiconductor defined by these values may have relatively low resistivity.
In an embodiment, there is presented an n-type semiconductor, wherein:

- the value of x is equal to or larger than 0.090,
- the value of x is equal to or less than 0.110,
- the value of y is equal to or larger than 0.008,
- the value of y is equal to or less than 0.012.

An advantage of this embodiment may be that a semiconductor defined by these values may have relatively low resistivity.
In an embodiment, there is presented an n-type semiconductor, wherein:

- the value of y is substantially equal to 0.010,
- the value of x is substantially equal to or larger than 0.090,
- the value of x is equal to or less than 0.110.

An advantage of this embodiment may be that a semiconductor defined by these values may have relatively low resistivity.
In an embodiment, there is presented an n-type semiconductor, wherein:

- the value of z is equal to or less than 1-x-y.

An advantage of this embodiment may be that a semiconductor defined by these values may have relatively low resistivity.
In an embodiment, there is presented an n-type semiconductor, being suitable for use as a transparent and/or conductive oxide, such as a transparent conductive oxide (TCO), such as a transparent conductive oxide (TCO) suitable for use in an associated system or device.
In an embodiment, there is presented an n-type semiconductor, wherein the sum of x and y is less than unity and wherein z is within 0.50 and 1.0, such as within 0.80 and 0.99, such as within 0.80 and 0.95, such as within 0.80 and 0.949, such as within 0.810 and 0.944.
'Unity' is understood to correspond to the number 1 (one).
In an embodiment, there is presented an n-type semiconductor, wherein the sum of x and y is less than unity and wherein z is substantially equal to 1-x-y, such as wherein z is equal to 1-x-y.
In an embodiment, there is presented an n-type semiconductor comprising gallium doped zinc cadmium oxide, consisting of the elements zinc, cadmium, gallium and oxygen, and optionally 1 or 2 further elements.
In an embodiment, there is presented an n-type semiconductor, wherein the resistivity (ρ) at room temperature is equal to or less than $2.0 \times 10^{-3}$ Ωcm, such as equal to or less than $1.5 \times 10^{-3}$ Ωcm, such as equal to or less than $1.25 \times 10^{-3}$ Ωcm, such as equal to or less than $1 \times 10^{-3}$ Ωcm, such as equal to or less than $0.85 \times 10^{-3}$ Ωcm, such as equal to or less than $0.75 \times 10^{-4}$ Ωcm, such as equal to or less than $2.0 \times 10^{-4}$ Ωcm. An advantage of this embodiment may be that relatively low resistivity values mayh entail lower resistance values of elements formed from the semiconductor, which may in turn entail less loss of energy when current is propagating through said elements.

By 'room temperature' (RT) may in general be understood 290-310 K, such as 300 K.

In an embodiment, there is presented an n-type semiconductor, wherein the absorption coefficient ($\alpha$) at 550 nm is equal to or less than 10000 cm$^{-1}$, such as equal to or less than 5000 cm$^{-1}$, such as equal to or less than 4000 cm$^{-1}$, such as equal to or less than 3000 cm$^{-1}$, such as equal to or less than 2500 cm$^{-1}$, such as equal to or less than 2300 cm$^{-1}$, such as equal to or less than 2200 cm$^{-1}$. An advantage of this embodiment may be that relatively low absorption coefficient ($\alpha$) may entail higher transmittance of elements formed from the semiconductor which may in turn entail less loss of light (in this case at 550 nm) when light is propagating through said elements.

It is noted that this absorption coefficient ($\alpha$) at 550 nm for Ga-doped ZnCdO of 2200 cm$^{-1}$, is much lower compared to, e.g., tin doped indium oxide (ITO) and aluminum doped oxide (AZO), meaning that the present invention provides better transparency.

In an embodiment, there is presented an n-type semiconductor, wherein an average transmittance between 400 nm to 700 nm, as measured for a film of said semiconductor being 80 nm, is equal to or larger than 80 %, such as equal to or larger than 85 %, such as equal to or larger than 90 %, such as equal to or larger than 92 %, such as equal to or larger than 94 %. An advantage of this embodiment may be that relatively low transmittance may entail higher transmittance of elements formed from the semiconductor which may in turn entail less loss of light when light is propagating through said elements.

In an embodiment, there is presented an n-type semiconductor, wherein the band gap is equal to or larger than 3.0 eV, such as equal to or larger than 3.1 eV, such as equal to or larger than 3.2 eV, such as equal to or larger than 3.3 eV, such as equal to or larger than 3.4 eV, such as equal to or larger than 3.5 eV, such as equal to or larger than 3.6 eV. An advantage of the present embodiment, may be that generally, the larger optical band gap the less light is absorbed within the solar spectra, thus the relatively large band gap may enable making the semiconductor a good transparent conductive oxide (TCO).

In an embodiment, there is presented an n-type semiconductor, wherein the chemical stability is retained, such as the useful physical properties of the material is retained on the timescale of its expected usefulness, such as retained after a period of 1 week, such as 1 month, such as 1 year, such as 10 years. A chemical stable substance is one which retains its useful physical properties on the timescale of its expected usefulness. In particular, the usefulness is retained in the presence of air, moisture or heat, and under the expected conditions of application without changes of its chemical and structural properties.

In an embodiment, there is presented an n-type semiconductor, wherein the thermal stability, such as the stability of the semiconductor at elevated temperatures, such as within 100 °C to 1000 °C, such as at 100°C, is retained, such as retained in the presence of air, moisture or heat without changes of its chemical and structural properties.

In an embodiment, there is presented an n-type semiconductor, being arranged as a film, such as a film having a thickness being less than or equal to 100 micrometers, such as a film having a thickness being less than or equal to 10 micrometers, such as a film having a thickness being less than or equal to 1 micrometer, such as a film having a thickness being within 10 nm to 2000 nm, such as a film having a thickness being 80 nm.

In an embodiment, there is presented an n-type semiconductor, wherein a main part of the semiconductor has a crystal structure which is hexagonal and/or cubic.

In an embodiment, there is presented an n-type semiconductor, being placed on, such as deposited on, a substrate, such as any one of: a polymer, a transparent crystalline material, a soda lime glass, a sapphire substrate.

According to a second aspect, there is presented a system, such as a device, comprising an n-type semiconductor according to any one of the preceding claims, such as the system being any one of

a. a display,
b. a window, such as said n-type semiconductor being a coating on said window, such as said window being a multifunctional window,
c. a transparent electronic component, such as a transistor or a thin film transistor or a passive linear device or a capacitor or a thin film capacitor,
d. a transparent electronic circuit,
e. a solar cell.

This aspect of the invention is particularly, but not exclusively, advantageous in that improved systems or devices may be provided, which benefit from the properties of the n-type semiconductor, such as

- the low resistivity and/or
- the high optical transmittance and/or
- the low optical absorption coefficient and/or
- the relatively low costs for providing the n-type semiconductor and/or

- optionally the stability of the n-type semiconductor.

By a 'multifunctional window' is understood a window with multiple functionalities. This can for instance be a window that detects whether it is open, senses the temperature or blocks heat radiation.

As a particular system, there is presented a window with a coating comprising the n-type semiconductor, such as the coating being suitable for blocking (e.g., by reflection) infrared light.

According to a third aspect, the invention further relates to a method for preparing an n-type semiconductor according to the first aspect or any embodiment within the first aspect, the method comprising depositing the elements of the n-type semiconductor on a substrate, such as said depositing employing any one of: pulsed laser deposition (PLD), Sol-Gel spin coating, metal organic chemical vapour deposition (MOCVD), metal organic molecular beam deposition (MOMBD), spray pyrolysis, magnetron sputtering. This aspect of the invention is particularly, but not exclusively, advantageous for providing the material according to the first aspect, such as said material in the form of a thin film. The method may be seen as providing a repeatable, scalable, and/or easy way to provide the material, such as to provide the material as a thin film.

In an embodiment, there is presented a method, wherein a deposition temperature is less than 100 °C, such as less than 80 °C, such as less than 60 °C, such as within [0-100] °C, such as within [0; 80] °C, such as within [0; 60] °C, such as within [20; 100] °C, such as within [20; 80] °C, such as within [20-60] °C, such as within [15; 40] °C, such as within [290; 310] K, such as substantially at room temperature (RT), such as substantially at 300 K, such as at room temperature (RT), such as at 300 K.

In an embodiment, there is presented a method, wherein a deposition temperature is above 30 °C, such as above 40 °C, such as above 50 °C, such as above 75 °C, such as above 10 °C, such as above 125 °C, such as above 50 °C, such as within [30; 800] °C, such as within [40; 800] °C, such as within [50; 800] °C, such as within [75; 800] °C, such as within [100; 800] °C, such as within [125; 800] °C, such as within [150; 800] °C, such as within [30; 500] °C, such as within [40; 500] °C, such as within [50; 500] °C, such as within [75; 500] °C, such as within [100; 500] °C, such as within [125; 500] °C, such as within [150; 500] °C.

According to a fourth aspect, the invention further relates to use of an n-type semiconductor according to the first aspect or any embodiment within the first aspect as any one of: an electrode, an optical filter, an interference shield, an optical sensor a display, a window, such as using said n-type semiconductor as a coating on a window, a transparent electronic component, such as a transistor or a thin film transistor or a passive linear device or a capacitor or a thin film capacitor, a transparent electronic circuit, a solar cell. This aspect of the invention may for example be embodied by use of said material for

- transmission or reflection of light, and/or
- for conducting electrical current

within the mentioned applications or elsewhere.

The first, second, third and fourth aspect of the present invention may each be combined with any of the other aspects. These and other aspects of the invention will be apparent from and elucidated with reference to the embodiments described hereinafter.

BRIEF DESCRIPTION OF THE FIGURES

The n-type semiconductor comprising gallium doped zinc cadmium oxide $Zn_zCd_xGa_yO$ according to the invention will now be described in more detail with regard to the accompanying figures. The figures show one way of implementing the present invention and is not to be construed as being limiting to other possible embodiments falling within the scope of the attached claim set.

FIG. 1 shows a bulk pellet 102 of n-type semiconductor comprising gallium doped zinc cadmium oxide with the composition of $Zn_{1-x-y}Cd_xGa_yO$ (x=0.1, y=0.01).

FIG. 2 shows a PLD deposited thin film 204 of n-type semiconductor comprising gallium doped zinc cadmium oxide on a sapphire substrate

FIG. 3 shows an X-ray diffraction pattern of Ga-ZnCdO film on a sapphire substrate

FIG. 4 shows temperature dependence of electrical resistivity for $Zn_{0.88}Cd_{0.1}A_{0.02}O$ (A = Sc, Ga, Sn, Ce) and $Zn_{0.88}Cd_{0.1}Sc_{0.01}B_{0.01}O$ (B = Mg, Sn, Ce) samples

FIG. 5 shows temperature dependence of electrical resistivity for samples of an n-type semiconductor comprising gallium doped zinc cadmium oxide with the composition $Zn_{0.9-y}Cd_{0.1}Ga_yO$ (where y is given by: y = {0.006; 0.01; 0.02}).

FIG. 6 shows temperature dependence of electrical resistivity for samples of an n-type semiconductor comprising gallium doped zinc cadmium oxide with the composition $Zn_{0.99-x}Cd_xGa_{0.01}O$ (where x is given by: x = {0.08; 0.10; 0.12}).

FIG. 7 shows deposition temperature dependence of electrical resistivity for thin films of an n-type semiconductor comprising gallium doped zinc cadmium oxide, which have been deposited at various temperatures,

FIG. 8 shows a spectrum showing the transmittance as a function of wavelength for a thin film of an n-type semiconductor comprising gallium doped zinc cadmium oxide with the composition $Zn_{0.89}Cd_{0.1}Ga_{0.01}O$ of 80 nm thickness

FIG. 9 illustrates Band gap estimation for an n-type semiconductor comprising gallium doped zinc cadmium oxide with the composition $Zn_{0.89}Cd_{0.1}Ga_{0.01}O$.

## DETAILED DESCRIPTION OF AN EMBODIMENT

*Material processing*

Ga-doped ZnCdO can be obtained by e.g. a conventional solid-state-reaction (SSR) from the precursors of ZnO, CdO and $Ga_2O_3$.

In the present example, the powders were mixed at the right molar ratio by roll milling using ceramic balls for 24 hr. Roll-mixing is an effective method for homogenizing the starting powder. The starting powder often consists of two or more than two component powders, for example ZnO, CdO and $Sc_2O_3$. First, the powders were weighed to the right amount and added together into a polyethylene bottle. Zirconia cylinders or balls were also added into the bottle as a mixing aid. Then the absolute ethanol with 1-2 wt% (weight percent) with respect to the powders was added. After that, the bottles were sealed and attached with the right safety labels. The mixing speed is 40 rpm and the time is for 24 hours. When the mixing procedure is finished, the resulting mixture was then uniaxially pressed with stainless steel die under 65 MPa for 60 seconds followed by isostatic pressing under 5 GPa for 60 seconds. The uniaxial pressing was using stainless steel dies with an inner diameter of 20 mm. About 6 to 8 grams of powder was added into the die and a pressing force of 18 kN (~2 Tons) was applied for 60 sec. The isostatic pressing was following the uniaxial pressing. The samples were first wrapped with an ultrasonic rubber bag, and then immerged into the isostatic pressing mould filled with water. A pressing force of 450 kN (~ 50 Tons) was applied for 60 sec. The green body was sintered in chamber furnace at 850 °C for 24 hr in air and then 1300 °C for 5 hr in air atmosphere to maintain the oxygen stoichiometry. The SSR method is using the conventional chamber furnace or tube furnace for sintering. The heating up and cooling down ramping rate was 300 K/h. More generally, doped Zinc Cadmium Oxide ($Zn_{1-x-y}Cd_xA_yO$, A = Sc, Ga, Ce, Mg, Sn etc.) may be obtained along a similar route from the starting powders of ZnO, CdO, $Sc_2O_3$, $Ga_2O_3$, $Ce_2O_3$, MgO, $Sn_2O_3$.

The sintered body reaches a relative density of approximately 96 %.

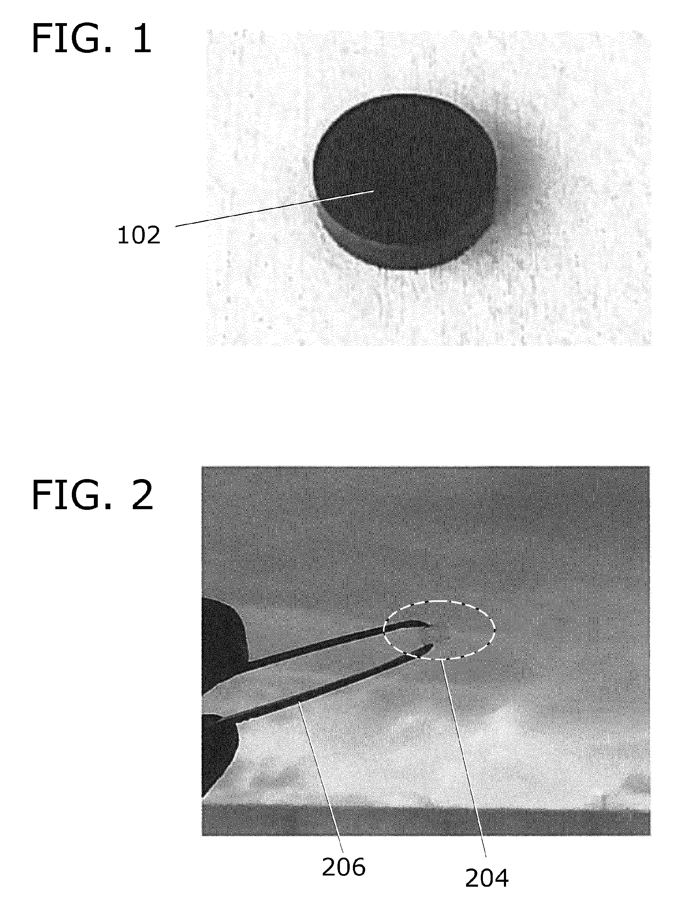

FIG. 1 shows a bulk pellet 102 of n-type semiconductor comprising gallium doped zinc cadmium oxide with the composition of $Zn_{1-x-y}Cd_xGa_yO$ (x=0.1, y=0.01). The bulk pellet of may function as a target, such as a target for production of thin films, such as a pulsed laser deposition (PLD) target. The main phase is composed of $Zn_{0.89}Cd_{0.1}Ga_{0.01}O$ with the crystalline structure of wurtzite belonging to the space group of P63mc, similar to pure ZnO. The lattice constants for this material (in Ångstrøm) are a = 3.29 Å, c = 5.25 Å.

FIG. 2 shows a PLD deposited thin film 204 of n-type semiconductor comprising gallium doped zinc cadmium oxide on a sapphire substrate, which is held by a standard tweezer 206 and seen against a blue sky background. The film is deposited from the target shown in FIG. 1.

*Material characterization*

Measurements of the properties of the material have been conducted. For the thin film samples, the electrical conductivity was measured using a 4-point-probe static DC method. For the bulk samples, the electrical resistivity ($\rho$) was measured using an ULVAC-RIKO ZEM-3 under a low pressure of helium atmosphere from room temperature up to 1173 K. Before the measurements for electrical conductivity and Seebeck coefficient, samples were cut into about $4\times4\times12$ mm$^3$ rectangular shape. The Seebeck coefficient was obtained by fitting the slope of the voltage difference dV against the temperature difference dT measured by two thermocouples.

Hall measurement was carried out at room temperature by van der Pauw method with a superconducting magnet (measured up to 2 T). Samples were cut into about 5x5x1 mm$^3$ squared pellets with contacts at four corners. The van der Pauw method was used with a superconducting magnet (5.08 T).

X-ray diffraction (XRD) pattern to examine the phase purity of the materials was obtained using a Bruker D8 diffractometer (Bruker, Germany) with Cu-K$\alpha$ radiation. The phases were analyzed and identified with EVA software and the XRD refinements were performed using TOPAS.

Transmittance was measured by Cary 50 UV-Visible Spectrophotometer. Absorption coefficient was calculated from the transmittance and the thickness of the film.

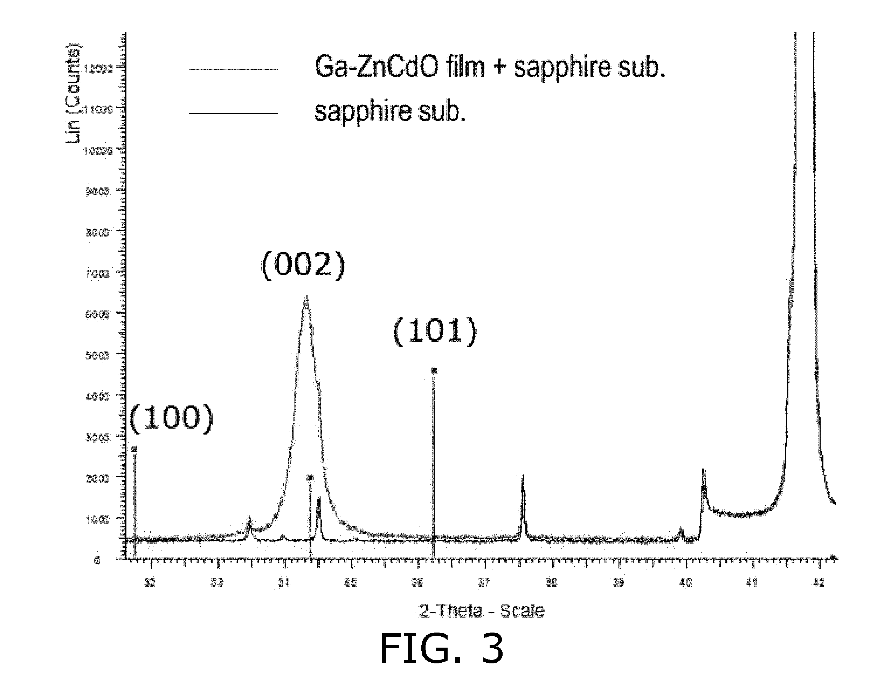

FIG. 3 shows an X-ray diffraction pattern of Ga-ZnCdO film on a sapphire substrate which corresponds to the film shown in FIG. 2. The figure shows both the pattern for the film on the substrate (this is the grey, uppermost curve) and the pattern for the sapphire substrate on its own (this is the black, lowermost curve). The film was deposited at 300 °C in vacuum. The material has hexagonal crystal structure. The thickness of the film for which the present pattern has been obtained is approximately 80 nm. The substrate for the thin film is in this case sapphire. The deposition method for the present material is PLD.

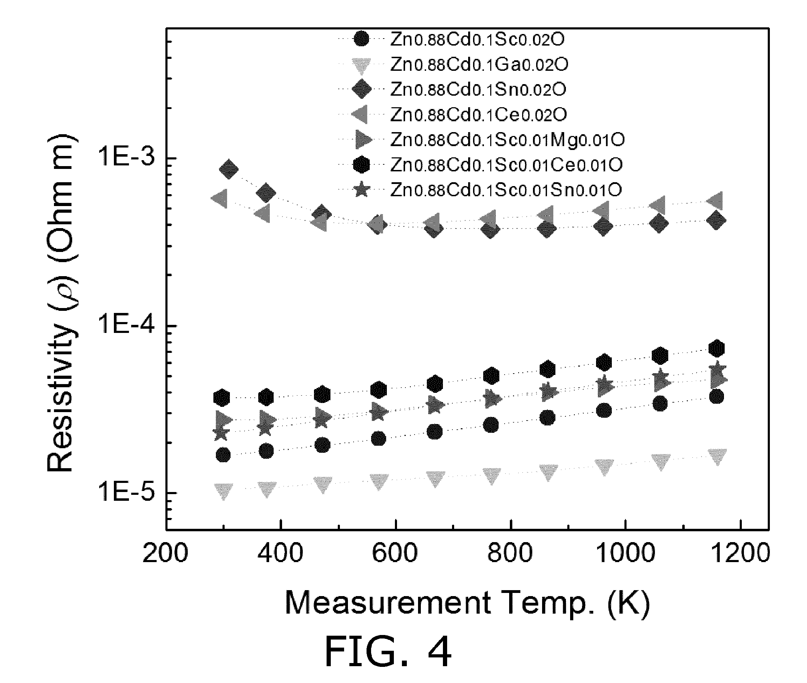

FIG. 4 shows temperature dependence of electrical resistivity for $Zn_{0.88}Cd_{0.1}A_{0.02}O$ (A = Sc, Ga, Sn, Ce) and $Zn_{0.88}Cd_{0.1}Sc_{0.01}B_{0.01}O$ (B = Mg, Sn, Ce) samples. It is noted, that this figure in particular shows that the resistivity throughout the range wherein the temperature dependence of electrical resistivity is measured, is lowest for $Zn_{0.88}Cd_{0.1}Ga_{0.02}O$ samples.

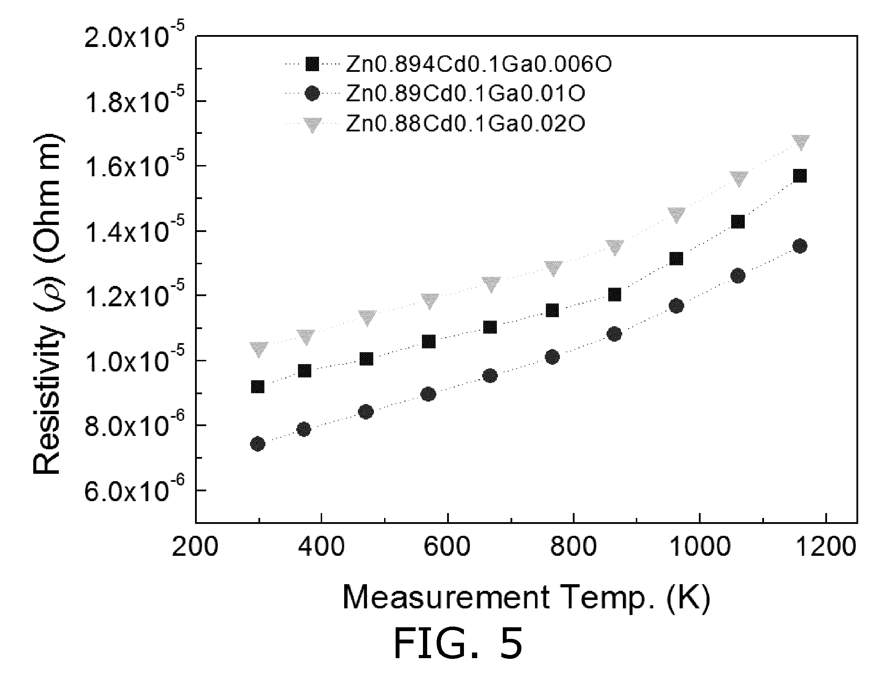

FIG. 5 shows temperature dependence of electrical resistivity for samples of an n-type semiconductor comprising gallium doped zinc cadmium oxide with the composition $Zn_{0.9-y}Cd_{0.1}Ga_yO$ (where y is given by: y = {0.006; 0.01; 0.02}). It is noted, that this figure shows that the resistivity throughout the range wherein the temperature dependence of electrical resistivity is measured, is lowest for the composition with y = 0.01.

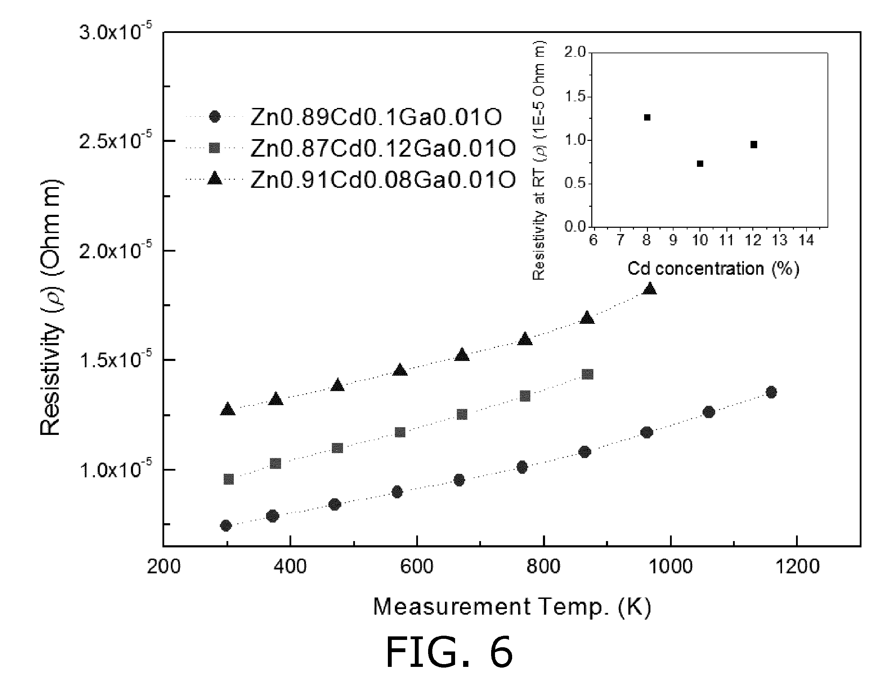

FIG. 6 shows temperature dependence of electrical resistivity for samples of an n-type semiconductor comprising gallium doped zinc cadmium oxide with the composition $Zn_{0.99-x}Cd_xGa_{0.01}O$ (where x is given by: x = {0.08; 0.10; 0.12}). It is noted, that this figure shows that the resistivity throughout the range wherein the temperature dependence of electrical resistivity is measured, is lowest for the composition with x = 0.10.

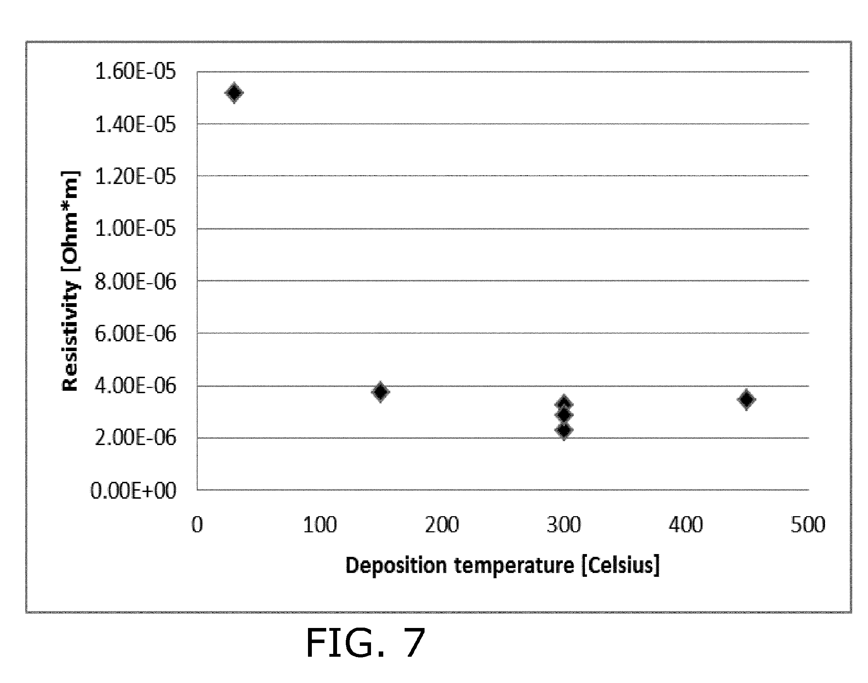

FIG. 7 shows deposition temperature dependence of electrical resistivity for thin films of an n-type semiconductor comprising gallium doped zinc cadmium oxide with the composition $Zn_{0.89}Cd_{0.1}Ga_{0.01}O$, which have been deposited at various temperatures. It can be seen from the graph that when depositing at an elevated temperature, such as above 30 °C, such as above 100 °C, such as above 150 °C, then a relatively low resistivity may be obtained. The PLD deposition parameters:

Deposition time: 75 min,
Shooting Frequency: 30 Hz,
Laser energy: 13 mJ,
Fluence: 1.06 J/cm$^2$,
Oxygen partial pressure: 4x10$^{-5}$ mBar,
Deposition temperatures (°C): 30, 150, 300, 450.

Measurements of the electrical transport properties of $Zn_{1-x-y}Cd_xGa_yO$ (x=0.1, y=0.01) film are shown in TABLE 1. The film was deposited on a sapphire substrate by PLD method, with the thickness 80 nm. The film was prepared with the composition $Zn_{0.89}Cd_{0.1}Ga_{0.01}O$, using the target shown in FIG. 1. The deposition parameters for the film in TABLE 1 are given by:

Deposition time: 30 min,
Shooting Frequency: 10 Hz,
Laser energy: 20 mJ,
Fluence: 1.46 J/cm$^2$,
Oxygen partial pressure: 1x10$^{-5}$ mBar,
Deposition temperature (°C): 300.

The new material has electrical resistivity on the order of $10^{-4}$ $\Omega$cm. The carrier mobility is on the order of 20 cm$^2$/(Vs) and the carrier density on the order of $4x10^{20}$ cm$^{-3}$. Overall, the electrical transport properties are very good.

TABLE 1

| Measurment Temperature (K) | Sheet Resistance ($\Omega$) | Resistivity ($\Omega$ cm) | Conductivity (S cm$^{-1}$) | Carrier Density (cm$^{-3}$) | Carrier mobility (cm$^2$/Vs) |
|---|---|---|---|---|---|
| 299 | 95 | $7.6 \times 10^{-4}$ | $1.315 \times 10^3$ | $4 \times 10^{20}$ | 20.56 |

In an alternative embodiment, where the resistivity is 2.3x10$^{-6}$ Ohm*m, the deposition parameters are:

Deposition time: 75 min,
Shooting Frequency: 30 Hz,
Laser energy: 18 mJ,

Fluence: 1.44 J/cm$^2$,
Oxygen partial pressure: 4x10$^{-5}$ mBar,
Deposition temperature (°C): 300.

More generally, properties of the n-type semiconductor according to various embodiments can be found in TABLE 2.

TABLE 2

| Sample | Resistivity ($\Omega$ cm) | Carrier concentration ($10^{19}$ cm$^{-3}$) | Carrier mobility (cm$^2$V$^{-1}$S$^{-1}$) |
|---|---|---|---|
| Bulk $Zn_{0.88}Cd_{0.1}Ga_{0.02}O$ | $1.04 \times 10^{-3}$ | 15.6 | 48.8 |
| Bulk $Zn_{0.89}Cd_{0.1}Ga_{0.01}O$ | $7.43 \times 10^{-4}$ | 13.1 | 64.3 |
| Thin film $Zn_{0.89}Cd_{0.1}Ga_{0.01}O$ | $7.6 \times 10^{-4}$ | 40 | 20.56 |

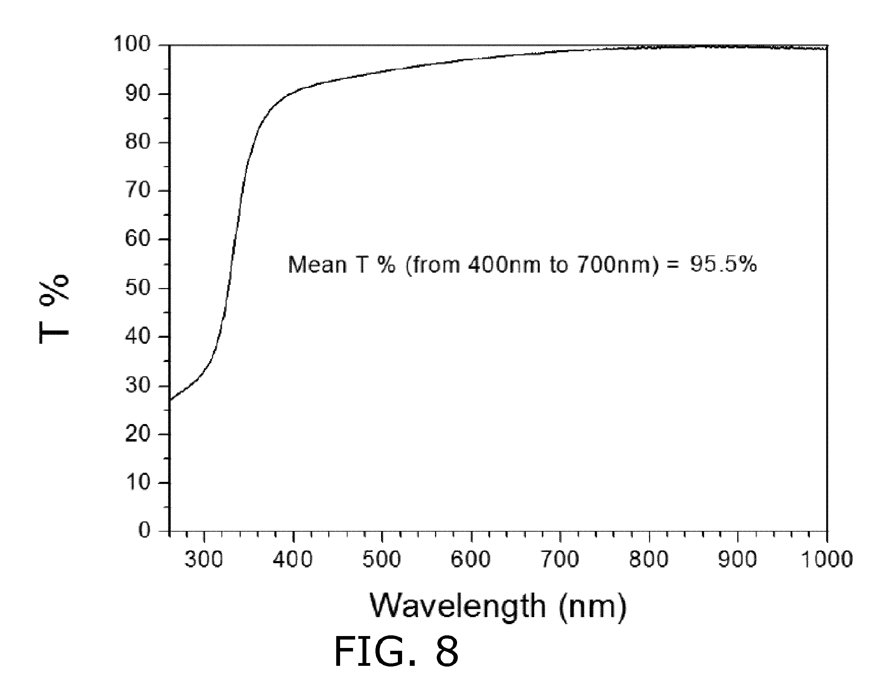

FIG. 8 shows a spectrum showing the transmittance as a function of wavelength for a thin film of an n-type semiconductor comprising gallium doped zinc cadmium oxide with the composition $Zn_{0.89}Cd_{0.1}Ga_{0.01}O$ of 80 nm thickness deposited on a sapphire substrate by PLD method. The average transmittance (T) at a wavelength of 550 nm is approximately 96%. The average transmittance in a region from 400 nm to 700 nm is approximately 95.5 %.

The absorption coefficient ($\alpha$) for Ga-doped ZnCdO (with composition $Zn_{0.89}Cd_{0.1}Ga_{0.01}O$) is 2200 cm$^{-1}$ at 550 nm.

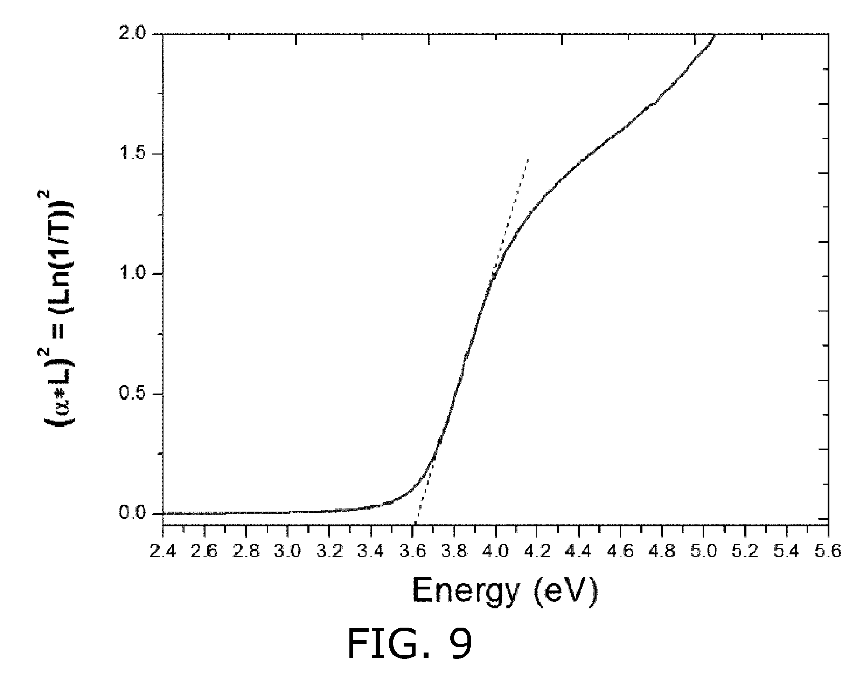

FIG. 9 illustrates Band gap estimation for an n-type semiconductor comprising gallium doped zinc cadmium oxide with the composition $Zn_{0.89}Cd_{0.1}Ga_{0.01}O$, which has a large optical band gap of approximately 3.62 eV (photon wavelength 340 nm). Band gap estimation was derived from the optical transmission spectra by extrapolating the linear portion of the plot of $(Ln(1/T))^2$ versus photon energy, as shown in the figure.

To sum up, There is presented an n-type semiconductor which may be useful as a TCO material: gallium doped zinc cadmium oxide (which may be interchangeably referred to as: Ga-doped ZnCdO) with the general formula $Zn_{1-x-y}Cd_x$-$Ga_yO$, where x and y may in a particular embodiment be given by, e.g., 0.05<x<0.15, 0.006<y<0.04. The semiconductor has excellent high transparency, with minor light absorption over the solar spectra, and high electrical conductivity, and may be provided in a relatively cost effective manner, and may furtermore be seen as less costly, and/or more stable and/or having lower resistivity and/or being more transparent, and optionally being depositable at room temperature, compared to known materials. The material has been successfully synthesized and tested in the laboratory.

Although the present invention has been described in connection with the specified embodiments, it should not be construed as being in any way limited to the presented examples. The scope of the present invention is set out by the accompanying claim set. In the context of the claims, the terms "comprising" or "comprises" do not exclude other possible elements or steps. Also, the mentioning of references such as "a" or "an" etc. should not be construed as excluding a plurality. The use of reference signs in the claims with respect to elements indicated in the figures shall also not be construed as limiting the scope of the invention. Furthermore, individual features mentioned in different claims, may possibly be advantageously combined, and the mentioning of these features in different claims does not exclude that a combination of features is not possible and advantageous.

**Claims**

1. An n-type semiconductor comprising gallium doped zinc cadmium oxide $Zn_zCd_xGa_yO$, optionally doped with one or more further dopants, wherein:

   - the value of x is equal to or larger than 0.050,
   - the value of x is equal to or less than 0.150,
   - the value of y is equal to or larger than 0.001,
   - the value of y is equal to or less than 0.019,
   - the value of z is equal to or larger than 0.300,

   and/or wherein

   - the value of x is equal to or larger than 0.081,
   - the value of x is equal to or less than 0.150,

- the value of y is equal to or larger than 0.001,
- the value of y is equal to or less than 0.040,
- the value of z is equal to or larger than 0.300.

2. An n-type semiconductor according to any one of the preceding claims, wherein:

- the value of x is equal to or larger than 0.081,
- the value of x is equal to or less than 0.150,
- the value of y is equal to or larger than 0.001,
- the value of y is equal to or less than 0.019.

3. An n-type semiconductor according to any one of the preceding claims, wherein:

- the value of x is equal to or larger than ¤0.085,
- the value of x is equal to or less than 0.130,
- the value of y is equal to or larger than 0.005,
the value of y is equal to or less than 0.019.

4. An n-type semiconductor according to any one of the preceding claims, wherein:

- the value of x is equal to or larger than 0.085,
- the value of x is equal to or less than 0.120,
- the value of y is equal to or larger than 0.006,
- the value of y is equal to or less than 0.015,
- the value of z is equal to or less than 1-x-y.

5. An n-type semiconductor according to any one of the preceding claims, wherein:

- the value of z is equal to or less than 1-x-y.

6. An n-type semiconductor according to any one of the preceding claims, wherein the resistivity ($\rho$) at room temperature is equal to or less than $2.0 \times 10^{-3}$ $\Omega$cm, such as equal to or less than $1.5 \times 10^{-3}$ $\Omega$cm, such as equal to or less than $1.25 \times 10^{-3}$ $\Omega$cm, such as equal to or less than $1 \times 10^{-3}$ $\Omega$cm, such as equal to or less than $0.85 \times 10^{-3}$ $\Omega$cm, such as equal to or less than $0.75 \times 10^{-4}$ $\Omega$cm, such as equal to or less than $2.0 \times 10^{-4}$ $\Omega$cm.

7. An n-type semiconductor according to any one of the preceding claims, wherein the absorption coefficient ($\alpha$) at 550 nm is equal to or less than 10000 $cm^{-1}$, such as equal to or less than 5000 $cm^{-1}$, such as equal to or less than 4000 $cm^{-1}$, such as equal to or less than 3000 $cm^{-1}$, such as equal to or less than 2500 $cm^{-1}$, such as equal to or less than 2300 $cm^{-1}$, such as equal to or less than 2200 $cm^{-1}$.

8. An n-type semiconductor according to any one of the preceding claims, wherein an average transmittance between 400 nm to 700 nm, as measured for a film of said semiconductor being 80 nm, is equal to or larger than 80 %, such as equal to or larger than 85 %, such as equal to or larger than 90 %, such as equal to or larger than 92 %, such as equal to or larger than 94 %.

9. An n-type semiconductor according to any one of the preceding claims, wherein the band gap is equal to or larger than 3.0 eV, such as equal to or larger than 3.1 eV, such as equal to or larger than 3.2 eV, such as equal to or larger than 3.3 eV, such as equal to or larger than 3.4 eV, such as equal to or larger than 3.5 eV, such as equal to or larger than 3.6 eV.

10. An n-type semiconductor according to any one of the preceding claims, being arranged as a film, such as a film having a thickness being less than or equal to 100 micrometers, such as a film having a thickness being less than or equal to 10 micrometers, such as a film having a thickness being less than or equal to 1 micrometer, such as a film having a thickness being within 10 nm to 2000 nm.

11. A system, such as a device, comprising an n-type semiconductor according to any one of the preceding claims, such as the system being any one of

a. a display,
b. a window, such as said n-type semiconductor being a coating on said window, such as said window being a multifunctional window,
c. a transparent electronic component, such as a transistor or a thin film transistor or a passive linear device or a capacitor or a thin film capacitor,
d. a transparent electronic circuit,
e. a solar cell.

12. A method for preparing an n-type semiconductor according to any one of claims 1-10, the method comprising depositing the elements of the n-type semiconductor on a substrate, ¤such as said depositing employing any one of: pulsed laser deposition (PLD), Sol-Gel spin coating, metal organic chemical vapour deposition (MOCVD), metal organic molecular beam deposition (MOMBD), spray pyrolysis, magnetron sputtering.

13. A method according to claim 12, wherein a deposition temperature is less than 100 °C, such as less than 80 °C, such as less than 60 °C, such as within [0-100] °C, such as within [0; 80] °C, such as within [0; 60] °C, such as within [20; 100] °C, such as within [20; 80] °C, such as within [20-60] °C, such as within [15; 40] °C, such as within [290; 310] K, such as substantially at room temperature (RT), such as substantially at 300 K, such as at room temperature (RT), such as at 300 K.

14. A method according to any one of claims 12-13, wherein a deposition temperature is above 30 °C, such as above 40 °C, such as above 50 °C, such as above 75 °C, such as above 10 °C, such as above 125 °C, such as above 50 °C, such as within [30; 800] °C, such as within [40; 800] °C, such as within [50; 800] °C, such as within [75; 800] °C, such as within [100; 800] °C, such as within [125; 800] °C, such as within [150; 800] °C, such as within [30; 500] °C, such as within [40; 500] °C, such as within [50; 500] °C, such as within [75; 500] °C, such as within [100; 500] °C, such as within [125; 500] °C, such as within [150; 500] °C.

15. Use of an n-type semiconductor according to any one of claims 1-10 as any one of: an electrode, an optical filter, an interference shield, an optical sensor a display, a window, such as using said n-type semiconductor as a coating on a window, a transparent electronic component, such as a transistor or a thin film transistor or a passive linear device or a capacitor or a thin film capacitor, a transparent electronic circuit, a solar cell.

FIG. 1

102

FIG. 2

206     204

Ga-ZnCdO film + sapphire sub.

sapphire sub.

(002)

(101)

(100)

Lin (Counts)

2-Theta - Scale

FIG. 3

FIG. 4

EP 3 000 786 A1

FIG. 5

FIG. 6

FIG. 7

FIG. 8

EP 3 000 786 A1

EP 3 000 786 A1

FIG. 9

Europäisches
Patentamt

European
Patent Office

Office européen
des brevets

## EUROPEAN SEARCH REPORT

Application Number

EP 14 18 6931

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | VIJAYALAKSHMI S ET AL: "Characterization of cadmium doped zinc oxide (Cd : ZnO) thin films prepared by spray pyrolysis method", JOURNAL OF PHYSICS D: APPLIED PHYSICS, INSTITUTE OF PHYSICS PUBLISHING LTD, GB, vol. 41, no. 24, 21 December 2008 (2008-12-21), page 245403, XP020141174, ISSN: 0022-3727, DOI: 10.1088/0022-3727/41/24/245403 * the whole document * | 1-15 | INV. C01G11/00 H01L31/0224 H01L31/0296 H01L31/18 |
| A | HU J ET AL: "Atmospheric pressure chemical vapor deposition of gallium doped zinc oxide thin films from diethyl zinc, water, and triethyl gallium", JOURNAL OF APPLIED PHYSICS, AMERICAN INSTITUTE OF PHYSICS, US, vol. 72, no. 11, 1 December 1992 (1992-12-01), pages 5381-5392, XP002456097, ISSN: 0021-8979, DOI: 10.1063/1.351977 * the whole document * | 1-15 | |
| A | US 2005/285138 A1 (BURGENER ROBERT H II [US] ET AL BURGENER II ROBERT H [US] ET AL) 29 December 2005 (2005-12-29) * the whole document * | 1-15 | TECHNICAL FIELDS SEARCHED (IPC) C01G H01L |
| A | US 4 791 336 A (MORIMOTO KIYOSHI [JP] ET AL) 13 December 1988 (1988-12-13) * the whole document * | 1-15 | |

The present search report has been drawn up for all claims

| Place of search | Date of completion of the search | Examiner |
|---|---|---|
| Munich | 10 March 2015 | Besana, Sonia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 14 18 6931

This annex lists the patent family members relating to the patent documents cited in the above-mentioned European search report.
The members are as contained in the European Patent Office EDP file on
The European Patent Office is in no way liable for these particulars which are merely given for the purpose of information.

10-03-2015

| Patent document cited in search report | Publication date | Patent family member(s) | Publication date |
|---|---|---|---|
| US 2005285138 A1 | 29-12-2005 | US 2005285119 A1<br>US 2005285138 A1<br>US 2005287817 A1<br>WO 2006009781 A2<br>WO 2006009782 A2<br>WO 2006009783 A2 | 29-12-2005<br>29-12-2005<br>29-12-2005<br>26-01-2006<br>26-01-2006<br>26-01-2006 |
| US 4791336 A | 13-12-1988 | NONE | |

EPO FORM P0459

For more details about this annex : see Official Journal of the European Patent Office, No. 12/82